# EUROPÄISCHE PATENTANMELDUNG

(11) **EP 2 799 590 A2**
(43) Veröffentlichungstag der Anmeldung: **05.11.2014**
(21) Anmeldenummer: 14164638.0
(22) Anmeldetag: 14.04.2014
(51) Int. Cl.: C23C 14/06, C23C 16/27, C23C 16/26, E05B 19/26

(54) **Verfahren zur Beschichtung von Artikeln**

(30) Priorität: 30.04.2013 DE 102013207989
(71) Anmelder: Schunk Kohlenstofftechnik GmbH, 35452 Heuchelheim (DE)
(72) Erfinder: Weck , Rudolf, Dr., 35764 Sinn (DE); Gärtner, Ralf, 35633 Lahnau (DE)
(74) Vertreter: advotec.

(57) **Zusammenfassung**

Die Erfindung betrifft ein Verfahren zur Beschichtung von Artikeln, sowie einem mit dem Verfahren hergestellten Artikel, wobei der Artikel aus Metall oder Kunststoff besteht, und wobei der Artikel einer der folgenden Gegenstände oder zumindest ein Bauteil eines der Gegenstände ist: Schlüssel, Schloss, Brillengestell, Handgriff, Möbelstück, und wobei der Artikel mit einer amorphen Kohlenstoffschicht beschichtet wird, wobei der Artikel in einem DLC-Beschichtungsverfahren beschichtet wird.

## Beschreibung

Die Erfindung betrifft ein Verfahren zur Beschichtung von Artikeln, sowie einen mit dem Verfahren hergestellten Artikel, wobei der Artikel aus Metall oder Kunststoff besteht, und wobei der Artikel einer der folgenden Gegenstände oder zumindest ein Bauteil eines der Gegenstände ist: Schlüssel, Schloss, Brillengestell, Handgriff, Möbelstück.

Die vorgenannten Artikel sind aus dem Stand der Technik hinreichend bekannt und werden zu einer Vielzahl von Zwecken eingesetzt. Schlösser dienen zur Zugangskontrolle örtlicher Bereiche oder zur Kontrolle von technischen Funktionen. Je nach Einsatzort eines Schlosses kann dieses, beispielsweise im Außenbereich, unter Einwirkung von Feuchtigkeit leicht korrodieren. So ist es regelmäßig auch erforderlich Schlösser, beispielsweise mit Öl, zu schmieren um Korrosion zu vermeiden und eine leichte Gängigkeit der bewegten Bauteile zu gewährleisten. Medizinische Werkzeuge, insbesondere aus Metall, wie ein Skalpell oder dergleichen, können je nach verwendeten Legierungsbestandteilen des Metalls bioaktiv sein. Das heißt das Metall oder die Metalllegierung kann mit beispielsweise einem Gewebe chemisch reagieren. Insbesondere können die bestreffenden medizinischen Werkzeuge bei einem Kontakt mit einem Gewebe auch schnell korrodieren. Gleiches betrifft medizinische Implantate, wie beispielsweise sogenannte Herzschrittmacher. Insgesamt ist es bei medizinischen Anwendungen regelmäßig erforderlich die in diesem Zusammenhang verwendeten Artikel zu sterilisieren und vor Korrosion zu schützen. Dies betrifft insofern auch Brillengestelle, Handgriffe von Apparaturen oder Instrumenten, Möbelstücke, die sich in entsprechenden räumlichen Bereichen befinden sowie Bestecke. Bei diesen Artikeln ist es insbesondere erforderlich eine Kontamination eines Gewebes durch Kontakt mit den Artikeln zu verhindern. Mit Pulverlack beschichtete medizinische Artikel bieten keinen verlässlichen Schutz gegen eine Kontamination und sind vergleichsweise teuer herzustellen. Pulverlack weist weiterhin ein Nachteil auf, dass eine Schichtdicke einer Pulverlackbeschichtung regelmäßig variiert, wodurch eine Oberflächenkontur verändert wird.

Der vorliegenden Erfindung liegt daher die Aufgabe zugrunde, ein Verfahren zur Beschichtung von Artikeln sowie Artikel vorschlagen, die die aus dem Stand der Technik bekannten Nachteile vermeiden und kostengünstig herstellbar sind. Diese Aufgabe wird durch ein Verfahren mit den Merkmalen des Anspruchs 1 und einen Artikel mit den Merkmalen des Anspruchs 11 gelöst.

Bei dem erfindungsgemäßen Verfahren zur Beschichtung von Artikeln besteht der Artikel aus Metall oder Kunststoff, wobei der Artikel einer der folgenden Gegenstände oder zumindest ein Bauteil eines der Gegenstände ist: Schlüssel, Schloss, Brillengestell, Handgriff, Möbelstück, und wobei der Artikel mit einer amorphen Kohlenstoffschicht beschichtet wird.

Die Schicht aus amorphem Kohlenstoff auf dem Artikel bewirkt, dass das Metall oder der Kunststoff, aus dem der Artikel ausgebildet ist, die Kohlenstoffschicht nicht durchdringen kann, so dass keine Kontamination erfolgen kann. So ist Kohlenstoff regelmäßig nicht störend. Auch ist die Beschichtung durch eine hohe Abriebfestigkeit und eine glatte Oberfläche gekennzeichnet. Die Beschichtung ist korrosionsbeständig und weist eine Härte von ca. 2.500 bis 3.000 HV auf. Darüber hinaus hat die Beschichtung eine schwarze Farbe, so dass eventuelle Beschädigungen der Beschichtung leicht erkannt werden können. Da beispielsweise medizinische Werkzeuge aus Metall polierte Oberflächen aufweisen, kann durch die Kohlenstoffschicht eine gegebenenfalls unerwünschte Blendwirkung aufgrund der im Wesentlichen schwarz erscheinenden Kohlenstoffschicht vermieden werden. Insgesamt ist es so möglich, robuste und kostengünstige Artikel herzustellen, die eine unerwünschte Kontamination vermeiden können.

Die Gegenstände bzw. Artikel Schlüssel und Handgriff können einstückig ausgebildet sein und sind daher besonders leicht zu beschichten. Die Gegenstände bzw. Artikel Schloss, Brillengestell und Möbelstück können aus mehreren Bauteilen bestehen, wobei dann die einzelnen Bauteile der Gegenstände mit einer amorphen Kohlenstoffschicht beschichtet werden.

Bei den Gegenständen Schlüssel, Schloss, Brillengestell und Möbelstück ist es besonders vorteilhaft, dass auf eine zusätzliche Schmierung bewegter Bauteile, die mit der amorphen Kohlenstoffschicht beschichtet sind, verzichtet werden kann. Diese Gegenstände bzw. Artikel können auch besonders maßhaltig hergestellt werden, da eine Schichtdicke der Kohlenstoffschicht nicht von einer Kontur des Gegenstands beeinflusst ist. Vorzugsweise ist das erfindungsgemäße Verfahren auch zur Beschichtung von Gegenständen im Bereich der Hochdrucktechnik einzusetzen.

Erfindungsgemäß wird der Artikel in einem DLC-Beschichtungsverfahren (diamond-like carbon) beschichtet. Mit einem derartigen Verfahren kann ein diamantähnlicher Kohlenstoff auf einer Oberfläche eines der Artikel aufgebracht werden. Eine derartige Beschichtung ist bis 400 °C temperaturstabil, so dass die betreffenden Artikel auch bei hohen Temperaturen eingesetzt werden können. Weiter kann eine besonders glatte Oberfläche durch die Beschichtung erhalten werden, wodurch ein Anhaften eines Stoffs an dem Artikel wirkungsvoll vermieden werden kann.

Vorzugsweise kann eine Oberfläche des Artikels vollständig beschichtet werden. So kann sichergestellt werden, dass auch keine unbeabsichtigte bioaktive Kontamination über dem Artikel erfolgen kann.

Der Artikel kann mit einer Kohlenstoffschicht von maximal 5 µm Dicke beschichtet werden. Eine Kohlenstoffschicht dieser Dicke ist ausreichend fest und widerstandsfähig gegenüber eventuellen Beschädigungen bei einer Handhabung. Eine Schichtdicke kann vorzugsweise ca. 3 µm betragen, wobei die Schichtdicke unabhängig von einer Oberflächenkontur ist.

In einer Ausführungsform des Verfahrens kann der Artikel mit einer wasserstofffreien amorphen Kohlenstoffschicht beschichtet werden.

In einer weiteren Ausführungsform kann der Artikel mit einer tetraedrischen wasserstofffreien amorphen Kohlenstoffschicht beschichtet werden. Eine derartige Kohlenstoffschicht ist aufgrund ihrer Bindungsstruktur im Wesentlichen einer Diamantschicht gleichzusetzen.

Auch kann der Artikel vorteilhaft mit einer metallhaltigen wasserstofffreien amorphen Kohlenstoffschicht beschichtet werden.

Besonders vorteilhaft kann der Artikel mit einer wasserstoffhaltigen amorphen Kohlenstoffschicht mit einem Wasserstoffanteil von > 35 % beschichtet werden.

Ebenso kann der Artikel mit einer tetraedrischen wasserstoffhaltigen amorphen Kohlenstoffschicht mit einem Wasserstoffanteil von > 25 % beschichtet werden.

Weiter kann der Artikel mit einer metallhaltigen wasserstoffhaltigen amorphen Kohlenstoffschicht beschichtet werden. Eine derartige Kohlenstoffschicht weist eine besonders hohe Verschleißfestigkeit und einen geringen Reibkoeffizienten auf.

Auch kann der Artikel mit einer modifizierten, mit zumindest einem der Elemente Silizium, Sauerstoff, Stickstoff, Fluor und Bor dotierten, wasserstoffhaltigen amorphen Kohlenstoffschicht beschichtet werden. Eigenschaften der Kohlenstoffschicht können dann entsprechend der Dotierung wesentlich beeinflusst werden. Beispielsweise kann mittels Silizium eine Temperaturbeständigkeit in sauerstoffhaltiger Umgebung erhöht werden.

Der erfindungsgemäße Artikel ist mit dem erfindungsgemäßen Verfahren hergestellt. Vorteilhafte Ausführungsformen des Artikels ergeben sich aus den Merkmalsbeschreibungen der auf den Verfahrensanspruch 1 zurückbezogenen Unteransprüche.

## Patentansprüche

1. Verfahren zur Beschichtung von Artikeln, wobei der Artikel aus Metall oder Kunststoff besteht, und wobei der Artikel einer der folgenden Gegenstände oder zumindest ein Bauteil eines der Gegenstände ist:
Schlüssel, Schloss, Brillengestell, Handgriff, Möbelstück,
**dadurch gekennzeichnet,**
**dass** der Artikel mit einer amorphen Kohlenstoffschicht beschichtet wird, wobei der Artikel in einem DLC-Beschichtungsverfahren beschichtet wird

2. Verfahren nach Anspruch 1,
**dadurch gekennzeichnet,**
**dass** eine Oberfläche des Artikels vollständig beschichtet wird.

3. Verfahren nach Anspruch 1 oder 2,
**dadurch gekennzeichnet,**
**dass** der Artikel mit einer Kohlenstoffschicht von maximal 5 µm Dicke beschichtet wird.

4. Verfahren nach einem der Ansprüche 1 bis 3,
**dadurch gekennzeichnet,**
**dass** der Artikel mit einer wasserstofffreien amorphen Kohlenstoffschicht beschichtet wird.

5. Verfahren nach einem der Ansprüche 1 bis 3,
**dadurch gekennzeichnet,**
**dass** der Artikel mit einer tetraedrischen wasserstofffreien amorphen Kohlenstoffschicht beschichtet wird.

6. Verfahren nach einem der Ansprüche 1 bis 3,
**dadurch gekennzeichnet,**
**dass** der Artikel mit einer metallhaltigen wasserstofffreien amorphen Kohlenstoffschicht beschichtet wird.

7. Verfahren nach einem der Ansprüche 1 bis 3,
**dadurch gekennzeichnet,**
**dass** der Artikel mit einer wasserstoffhaltigen amorphen Kohlenstoffschicht mit einem Wasserstoffanteil von > 35 % beschichtet wird.

8. Verfahren nach einem der Ansprüche 1 bis 3,
**dadurch gekennzeichnet,**
**dass** der Artikel mit einer tetraedrischen wasserstoffhaltigen amorphen Kohlenstoffschicht mit einem Wasserstoffanteil von > 25 % beschichtet wird.

9. Verfahren nach einem der Ansprüche 1 bis 3,
**dadurch gekennzeichnet,**
**dass** der Artikel mit einer metallhaltigen wasserstoffhaltigen amorphen Kohlenstoffschicht beschichtet wird.

10. Verfahren nach einem der Ansprüche 1 bis 3,
**dadurch gekennzeichnet,**
**dass** der Artikel mit einer modifizierten, mit zumindest einem der Elemente Si, O, N, F und B dotierten, wasserstoffhaltigen amorphen Kohlenstoffschicht beschichtet wird.

11. Artikel, hergestellt nach einem Verfahren nach einem der vorangehenden Ansprüche.
